(19) Europäisches Patentamt
European Patent Office
Office européen des brevets

(11) Veröffentlichungsnummer: **0 093 967**
**B1**

(12) # EUROPÄISCHE PATENTSCHRIFT

(45) Veröffentlichungstag der Patentschrift: **22.07.87**

(51) Int. Cl.[4]: **C 07 C 97/10,** H 01 L 29/28, H 01 B 1/12, H 01 L 31/02

(21) Anmeldenummer: **83104170.2**

(22) Anmeldetag: **28.04.83**

(54) **Verfahren zur Herstellung von elektrisch leitfähigen Systemen aus substituierten Phenalenen, sowie die nach dem Verfahren hergestellten Produkte und deren Verwendung.**

(30) Priorität: **07.05.82 DE 3217097**

(43) Veröffentlichungstag der Anmeldung: **16.11.83 Patentblatt 83/46**

(45) Bekanntmachung des Hinweises auf die Patenterteilung: **22.07.87 Patentblatt 87/30**

(84) Benannte Vertragsstaaten: **BE DE FR GB NL**

(56) Entgegenhaltungen:
**EP-A-0 035 713**
**EP-A-0 054 136**

**ZEITUNG DER NATURFORSCHUNG, Teil B, Band 28, Nr.3-4, 1973, Seiten 164-167, DE; R. ADERJAN et al.: "Planare Dicarbonylrhodium(I)- und -iridium(I)-Komplexe mit polarisierbaren aromatischen Liganden"**
**INORGANIC NUCLEAR CHEMISTRY LETTERS, Band 10, Nr. 6, 1974, Seiten 468-470, Pergamon Press, GB; H. ENDRES et al.: "Electrical properties of two partially oxidized bis (1.2-benzoquinonedioximato) metal complexes"**

(73) Patentinhaber: **BASF Aktiengesellschaft, Carl-Bosch- Strasse 38, D-6700 Ludwigshafen (DE)**

(72) Erfinder: **Naarmann, Herbert, Dr., Haardtblick 15, D-6719 Wattenheim (DE)**
Erfinder: **Muench, Volker, Dr., Luitpoldstrasse 114, D-6700 Ludwigshafen (DE)**
Erfinder: **Koehler, Gernot, Dr., Berner Weg 32, D-6700 Ludwigshafen (DE)**
Erfinder: **Simak, Petr, Dr., Philipp- Scheidemann-Strasse 17, D-6700 Ludwigshafen (DE)**

Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

EP 0 093 967 B1

LIBER, STOCKHOLM 1987

**Beschreibung**

Die Erfindung betrifft ein Verfahren zur Herstellung von luftstabilen, elektrisch leitfähigen Systemen mit elektrischen Leitfähigkeitswerten größer als $1 \times 10^{-3}\ \Omega^{-1}cm^{-1}$ durch Umsetzen eines Metallkations der Elemente der VII., VIII. oder I. Nebengruppe des Periodischen Systems mit einem 1,9-substituierten Phenalen zu einem Metallchelatkomplex und dessen Oxidation zu dem elektrisch leitfähigen System. Die Erfindung betrifft desweiteren die nach diesem Verfahren hergestellten Produkte sowie deren Verwendung.

Bei dem erfindungsgemäßen Verfahren werden Übergangsmetallkationen $Me^{n\oplus}$ mit 1,9-substituierten Phenalenen zu Übergangsmetallchelatkomplexen mit quasi-eindimensionaler polymerer Struktur umgesetzt, bevor diese Chelatverbindungen oxidiert werden.

Es ist bereits bekannt, metallorganische Polymere mit direkter Metall-Metall-Wechselwirkung oder mit Metall-Ligand-Metall-Verknüpfung in quasi-eindimensionale elektrisch leitfähige Systeme zu überführen (vgl. M. Harnack, Nachr. Chem. Techn. Lab. 28 (9), 632 (1980)).

Beispiele für bekannte Polymersysteme von Übergangsmetallkationen sind Tetracyanoplatinat(II)komplexe, welche in sogenannten Kolumnarstrukturen mit Pt-Pt-Kontakten kristallisieren (vgl. Angew. Chem., 81, 10 (1964)). Durch partielle Oxidation dieser Komplexe entstehen gemischtvalente Polymere. Bekannt sind ferner bereits Übergangsmetallchelate mit Tetraazaporphinen, Phthalocyaninen, Dimethylglyoximen, Diphenylglyoximen, Dithioacetaten und anderen zur Metallchelatbildung geeigneten organischen Verbindungen (vgl. Annals of the New York Academy of Sciences, Synthesis and Properties of Low-Dimensional Materials, Edit. J.S. Miller and A.J. Epstein, Vol. 313, New York 1978, Seiten 9 ff, 25 ff, 594 ff und 633 ff). In Z. Naturforschung, Teil B (1973), Bd. 28 (3-4), Seiten 164-167 werden planare Dicarbonylrhodium(I)- und -iridium(I)-Komplexe mit polarisierbaren aromatischen Liganden beschrieben, wobei u.a. auch der Rhodium(I)-Komplex mit 9-Hydroxy-1-phenalenon erwähnt ist. Jedoch wird hierbei weder der Chelatkomplex des substituierten Phenalens besonders hervorgehoben noch seine Eignung für die Herstellung von luftstabilen, elektrisch leitfähigen Systemen angesprochen.

Es ist weiterhin bekannt, daß z.B. Bis(diphenylglyoximato)-Ni(II)komplexe, welche eben gebaut sind und in Stapeln kristallisieren, durch Oxidation mit Iod in die elektrisch leitfähige Verbindung Bis(diphenylglyoximato) Ni . I überführt werden können. Letztere weist gegenüber der Ausgangsverbindung einen Leitfähigkeitsanstieg um acht Größenordnungen auf $10^{-3}$ bis $10^{-2}\ \Omega^{-1}cm^{-1}$ auf (vgl. Inorg. Nucl. Chem. Lett., 10, 467 (1974)). Bei Verbindungen dieses Typs bilden die Iodidanionen polymere Ketten, die in Kanälen zwischen den Komplexstapeln in Stapelrichtung liegen und von den aromatischen Resten umgeben sind.

Weitere bekannte elektrisch leitfähige Polymere, z.B. mit Iod oxidierte Polyacetylene, weisen den Nachteil auf, daß sie unter striktem Luftausschluß hergestellt und gehandhabt werden müssen. Sie nehmen bei Kontakt mit Luft sehr rasch Sauerstoff auf, wobei ihre Leitfähigkeiten um ein bis zwei Größenordnungen sinken.

In der älteren europäischen Patentanmeldung EP-A-0054 136 wird vorgeschlagen, luftstabile, elektrisch leitfähige Polymere mit elektrischen Leitfähigkeitswerten größer als $10^{-3}\ \Omega^{-1}cm^{-}$ herzustellen, indem ein Metallkation der VII., VIII. oder I. Nebengruppe des Periodischen Systems der Elemente mit einem 1,9-substituierten Phenalen zu einem Metallchelatkomplex umgesetzt wird, der dann mit anorganischen Oxidationsmitteln, wie $AsF_5$, $SbF_5$, $SbCl_5$, $Cl_2$, $Br_2$ oder $I_2$, zu dem gewünschten Polymeren oxidiert wird.

Der Erfindung liegt die Aufgabe zugrunde, ein weiteres Verfahren aufzuzeigen, das es in einfacher Weise gestattet, neue elektrisch leitfähige Systeme mit elektrischen Leitfähigkeiten von über $1 \times 10^{-3}\ \Omega^{-1}cm^{-1}$ herzustellen, die an der Luft stabil sind. Diese Systeme sollen Leitfähigkeiten von über $10^{-3}\ \Omega^{-1}cm^{-1}$ schon als Pulver und nicht erst als hochgeordnete Einkristalle aufweisen und dadurch die Verwendbarkeit und Anwendungsbreite in der Elektrotechnik deutlich verbessern.

Diese Aufgabe wird erfindungsgemäß dadurch gelöst, daß man Übergangsmetallchelatkomplexe von 1,9-substituierten Phenalenen mit organischen Elektronenakzeptoren oxidiert.

Gegenstand der vorliegenden Erfindung ist demzufolge ein Verfahren zur Herstellung von luftstabilen, elektrisch leitfähigen Systemen mit elektrischen Leitfähigkeitswerten größer als $10^{-3}\ \Omega^{-1}cm^{-}$ durch Umsetzen eines Metallkations der Elemente der VII., VIII. oder I. Nebengruppe des Periodischen Systems der Elemente mit einem 1,9-substituierten Phenalen der allgemeinen Formel (I)

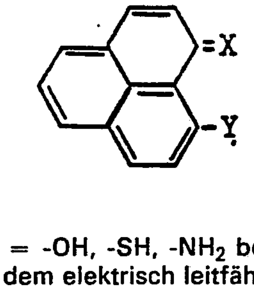

(I)

worin X = O, NH, S, Se oder Te und Y = -OH, -SH, $-NH_2$ bedeuten, zu einem Metallchelatkomplex und Oxidation dieses Metallchelatkomplexes zu dem elektrisch leitfähigen System mittels eines Oxidationsmittels. Das Verfahren ist dadurch gekennzeichnet, daß man als Oxidationsmittel organische Elektronenakzeptoren einsetzt.

Unter luftstabilen elektrisch leitfähigen Systemen werden solche mit polymerer Struktur und

Leitfähigkeitswerten von größer als 1 x $10^{-3}\Omega^{-1}cm^{-1}$ verstanden, welche sich in Luftatmosphäre bei Temperaturen von 0 bis 100°C über einen Zeitraum von mindestens 20 Tagen nicht zersetzen und stabil bleiben. Die elektrischen Leitfähigkeitswerte werden in $\Omega^{-1}cm^{-1}$ bei 30°C gemessen; die Messung selbst erfolgt nach der Methode F. Beck, Berichte Bunsengesellschaft, Physikalische Chemie 68, 558-567 (1964).

Bei dem erfindungsgemäßen Verfahren werden zunächst Metallkationen der Elemente der VII., VIII. oder I. Nebengruppe des Periodischen Systems mit 1,9-substituierten Phenalenen zu Metallchelatkomplexen umgesetzt.

Hierzu geht man von Metallkationen z.B. des Mn, Te, Re, Fe, Ru, Os, Co, Rh, Ir, Ni, Pd, Pt, Cu oder Ag, bevorzugt des Fe, Ni, Pd, Pt oder Cu, aus, die in Form eines Salzes, z.B. des Halogenids, Halogenokomplexes, Sulfats, Nitrats, Phosphats, Perchlorats, Trifluormethansulfonats oder Acetats eingesetzt werden. Geeignete Salze dieser Art sind z.B. Manganacetat, Eisen(II)sulfat, Kobalt(II)acetat, Nickel(II)acetat, Palladium(II)chlorid oder Kaliumtetrachloroplatinat(II). Besonders gut geeignet sind Nickel(II)acetat bzw. Palladiumsalze.

Als 1,9-substituierte Phenalene (Perinaphthylene) kommen solche der allgemeinen Formel (I)

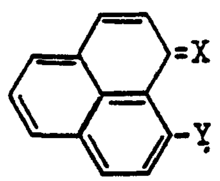

(I)

in Betracht, worin bedeuten X = O, NH, S, Se oder Te und Y = OH, $NH_2$ oder SH ist. Insbesondere günstig sind Verbindungen der Formel (I), in denen X gleich O, NH oder S, insbesondere aber O ist. Besonders bevorzugt ist die Verbindung mit X = O und Y = $NH_2$, das 9-Amino-1-phenalenon. Die erfindungsgemäß einzusetzenden Phenalene der Formel (I) sind an sich bekannt und in den Literaturstellen J. Org. Chem. 44, (1979), 1704; Tetrahedron, 34, (1978) 2147 und GB-PS 1 388 417 beschrieben. Sie sind völlig eben gebaute, ungeradzahlige aromatische $C_{13}$-Kohlenwasserstoffe.

Die Umsetzung der Metallsalze mit den 1,9-substituierten Phenalenen der allgemeinen Formel (I) erfolgt bevorzugt in Lösung. Metallsalz und substituiertes Phenalen werden dabei üblicherweise im stöchiometrischen Verhältnis miteinander umgesetzt, d.h. entsprechend dem Koordinationswert des Metallkations im Chelatkomplex. Die Umsetzungstemperatur liegt im allgemeinen im Bereich von 20°C bis Siedetemperatur des Lösungsmittels. Besonders bevorzugt werden in einem Ethanol-Wassergemisch (Volumenverhältnis 1 : 1) die Metallsalze aufgelöst und anschließend die Lösung mit dem in Ethanol gelösten substituierten Phenalen gemischt. Zur Beschleunigung der Umsetzung wird zweckmäßigerweise auf Siedetemperatur des Lösungsmittels, z.B. des Ethanol-Wasser-Gemisches, erhitzt. Hierbei fällt der schwerlösliche Metallchelatkomplex aus der Lösung aus und kann durch Umkristallisation aus einem höheren Alkohol, vorzugsweise aus n-Butanol, gereinigt und in wasserfreier Form isoliert werden. Nach einer weiteren besonders bevorzugten Verfahrensweise werden 1 Mol des jeweiligen 1,9-substituierten Phenalens in Ethanol gelöst vorgelegt und in der Siedehitze bei Temperaturen von 70 bis 80°C ein halbes Mol Nickel(II)acetat oder eines Pd(II)-Salzes in Ethanol/$H_2O$ (Volumenverhältnis 1: 1) dazugetropft. Dabei fallen in hoher Reinheit und Ausbeute die Metallchelatkomplexe aus.

Die Oxidation der in der ersten Verfahrensstufe hergestellten Metallchelatkomplexe wird erfindungsgemäß mit organischen Elektronenakzeptoren als Oxidationsmittel vorgenommen. Als geeignete Oxidationsmittel sind dabei insbesondere die Chinone, Chinonmethide und Nitroaromaten hervorzuheben.

Zu den Chinonen, wie sie beispielsweise in "The Chemistry of Quinoid Compounds" in "The Chemistry of Functional Groups", Part 1 and 2, Editor S. Patai, John Wiley Verlag, New York (1974) beschrieben sind, gehören u.a. die Benzochinone, Naphthochinone-1,4, Naphthochinone-1,6, Anthrachinone, mehrkernige Chinone sowie nichtbenzoide Chinone.

Bevorzugte Benzochinone sind solche der allgemeinen Formeln (IIa) und (IIb)

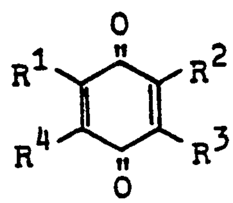

(IIa),

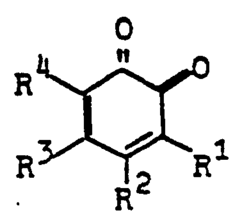

(IIb)

wobei die Reste $R^1$, $R^2$, $R^3$ und $R^4$ gleich oder verschieden sein können und H, F, Cl, Br, I, CN, $CF_3$, $C_2F_5$, OH, $NO_2$, $COOR^5$ oder $OR^5$ mit $R^5$ = einem Alkyl- (insbesondere $C_1$-$C_8$-Alkyl, wie $CH_3$-, $C_2H_5$-, $C_3H_7$- oder $C_4H_9$-) oder Cycloalkyl- (insbesondere $C_6$-$C_{12}$-Cycloalkyl, wie Cyclohexyl) oder Aryl-Rest (insbesondere $C_6$-$C_{12}$-Arylrest, wie Phenylrest) bedeuten. Das Oxidationspotential der Verbindungen liegt dabei im allgemeinen

umso höher, je mehr der Reste $R^1$ bis $R^4$ ungleich H sind. Daher sind in dem erfindungsgemäßen Verfahren diejenigen Verbindungen bevorzugt, in denen höchstens drei, vorzugsweise höchstens zwei der Reste $R^1$ bis $R^4$ gleich H sind. Insbesondere bevorzugt sind die Verbindungen, in denen die Reste $R^1$ bis $R^4$ Cl, Br, CN und/oder $CF_3$ bedeuten, wobei ein Teil dieser Reste auch H sein kann. Beispiele für geeignete Benzochinone sind p-Benzochinon, o-Benzochinon, p-Chloranil, p-Bromanil und p-Iodanil.

Zu den geeigneten Naphthochinonen gehören solche der allgemeinen Formeln (III) und (IV)

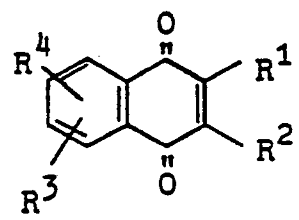
(III)

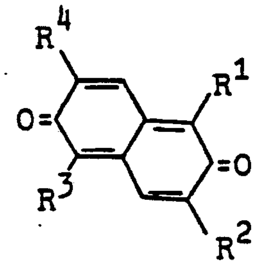
(IV),

worin die Reste $R^1$, $R^2$, $R^3$ und $R^4$ die oben angegebene Bedeutung haben.

Bei den Anthrachinonen kommen insbesondere solche der allgemeinen Formel (V)

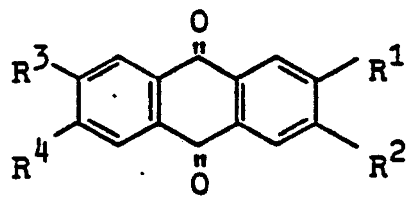
(V)

in Betracht, worin die Reste $R^1$ bis $R^4$ ebenfalls die oben angegebene Bedeutung haben.

Mehrkernige Chinone, die als Oxidationsmittel in dem erfindungsgemäßen Verfahren Anwendung finden können, haben beispielsweise die allgemeine Formel (VI)

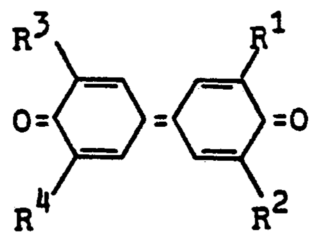
(VI),

wobei den Resten $R^1$ bis $R^4$ die oben genannte Bedeutung zukommt. Insbesondere vorteilhaft sind solche mehrkernigen Chinone der allgemeinen Formel (VI), in denen die Reste $R^1$ bis $R^4$ Methylgruppen sind, z.B. das Tetramethyldiphenochinon.

Als Beispiele für nichtbenzoide Chinone, die erfindungsgemäß eingesetzt werden können, seien die durch die nachfolgenden allgemeinen Formeln (VII) bis (XIV) gekennzeichneten Verbindungen genannt:

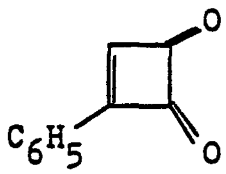 (VII), 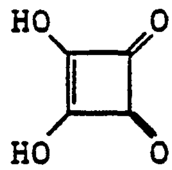 (VIII), 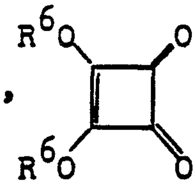 (IX),

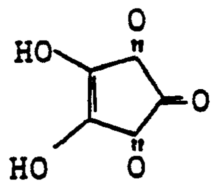 (X), 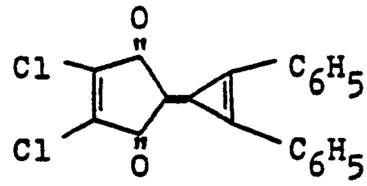 (XI),

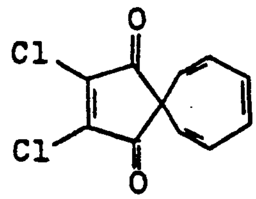 (XII), 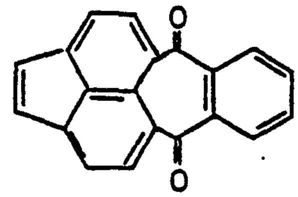 (XIII)

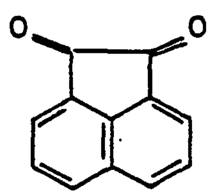 (XIV)

In der Formel (IX) ist $R^6$ dabei ein $C_1$-$C_4$-Alkylrest oder ein $C_6$-$C_{12}$-Cycloalkylrest, insbesondere $CH_3$-, $C_2H_5$- oder $C_6H_{11}$-.

Neben den Chinonen eignen sich als Oxidationsmittel in dem erfindungsgemäßen Verfahren gleichermaßen benzoide und/oder nichtbenzoide Chinonmethide, wie sie beispielsweise ebenfalls in dem vorgenannten Werk "The Chemistry of Quinoid Compounds" beschrieben werden. Bezüglich geeigneter Chinonmethide sei auch auf J.K. Perlstein, Angew. Chemie, Band 89, Seiten 534 bis 549 (1977) verwiesen. Als repräsentative Vertreter für die Chinonmethide seien angeführt:

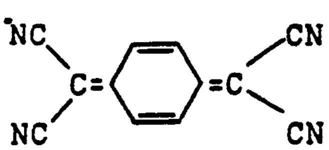 (XV), 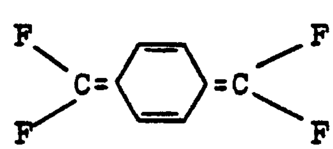 (XVI)

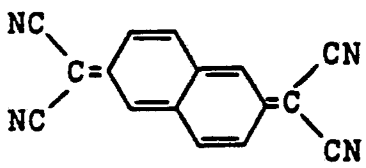 (XVII), 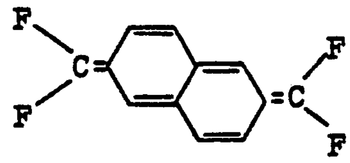 (XVIII)

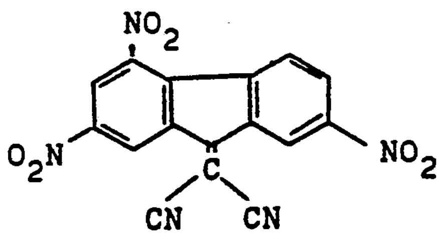 (XIX), 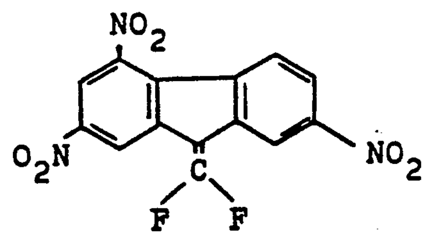 (XX)

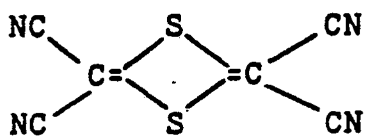 (XXI), 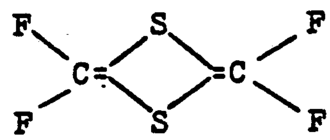 (XXII)

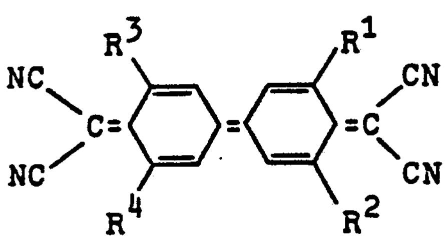 (XXIII), 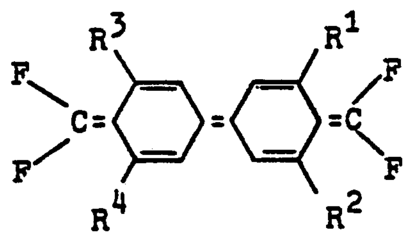 (XXIV)

In den Formeln (XXIII) und (XXIV) können die Reste $R^1$, $R^2$, $R^3$ und $R^4$ gleich oder verschieden sein und bedeuten H, F, Cl, Br, I; CN, $CF_3$, $C_2F_5$, OH, $NO_2$, $COOR^5$ oder $OR^5$ mit $R^5$ = einem Alkylrest (insbesondere $C_1$-$C_8$-Alkyl, vorzugsweise $CH_3$-, $C_2H_5$-, $C_3H_7$- oder $C_4H_9$), einem Cycloalkylrest (insbesondere $C_6$-$C_{12}$-Cycloalkyl, vorzugsweise $C_6H_{11}$-) oder einem Arylrest (insbesondere Phenyl). Von den Verbindungen der Formeln (XXIII) und (XXIV) sind diejenigen bevorzugt, in denen die Reste $R^1$ bis $R^4$ gleich sind und H, Cl, Br oder CN bedeuten.

Zu den organischen Elektronenakzeptoren, die mit besonderem Vorteil in dem erfindungsgemäßen Verfahren als Oxidationsmittel eingesetzt werden können, gehören ferner die bekannten Nitroaromaten, wie sie beispielsweise in "The Chemistry of Nitro- and Nitroso-Groups" Part 1 and 2, in "The Chemistry of Functional Groups", Series Editor S. Patai, Interscience Publishers, New York (1970) beschrieben sind. Beispielhaft für bevorzugt als Oxidationsmittel verwendete Nitroaromaten seien neben den oben erwähnten Verbindungen der Formeln (XIX) und (XX) genannt:

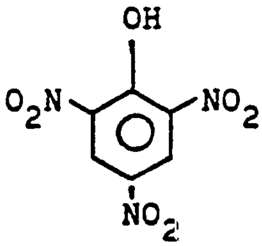 (XXV), 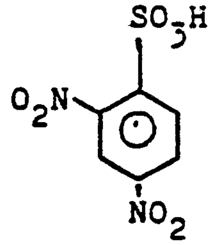 (XXVI), 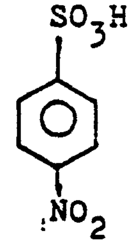 (XXVII)

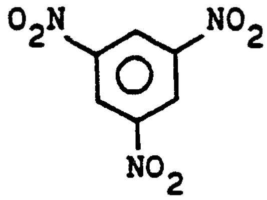 (XXVIII), 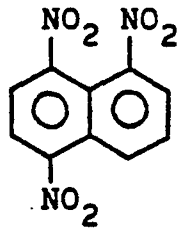 (XXIX)

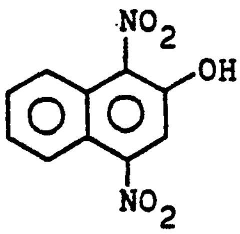 (XXX), 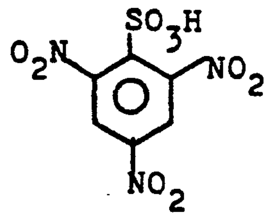 (XXXI)

Die Oxidation wird zweckmäßig in Gegenwart eines Lösungsmittels, vorzugsweise in chlorierten oder chlorfluorierten inerten Kohlenwasserstoffen, durchgeführt. Dazu werden die Metallchelatkomplexe im allgemeinen mit einem 1,5- bis 10-fachen molaren Überschuß der organischen Elektronenakzeptoren, die in einem geeigneten Lösungsmittel gelöst sind, bei Temperaturen um +40 bis +100°C mehrere Stunden bis Tage umgesetzt. Vorzugsweise erfolgt diese Umsetzung in chlorierten oder chlorfluorierten inerten Kohlenwasserstoffen in der Siedehitze. Dabei fallen die luftstabilen, elektrisch leitfähigen Systeme mit polymerer Struktur aus. Zur Erzielung maximaler elektrischer Leitfähigkeiten wird die Oxidation bevorzugt unter Inertgasatmosphäre ausgeführt, wobei als Inertgas vorzugsweise Argon oder Stickstoff verwendet wird.

Die unlöslichen, elektrisch leitfähigen polymeren Systeme werden durch Filtration von der Reaktionslösung abgetrennt, mit chlorierten oder chlorfluorierten Kohlenwasserstoffen gewaschen und mehrere Stunden im Vakuum getrocknet.

Das erfindungsgemäße Verfahren führt durch die Umsetzung der 1,9-substituierten Phenalene der allgemeinen Formel (I) mit einem Metallkation der Elemente der VII., VIII. oder I. Nebengruppe des Periodischen Systems, bevorzugt mit den Kationen des Fe, Ni, Pd, Pt oder Cu, besonders bevorzugt des Ni oder Pd, zunächst zu Bis(chelat)metallkomplexen der allgemeinen Formel (Ia)

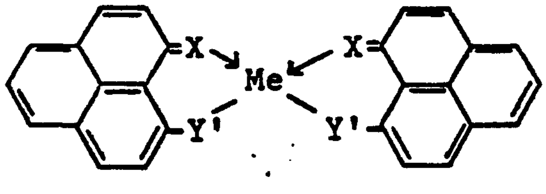 (Ia),

worin X = O, NH, S, Se oder Te; Y' = -O-, -NH- oder -S- und Me = Metall der angegebenen Art bedeuten. Vorzugsweise ist X = O, NH oder S, insbesondere aber O, und Y' = -O- oder -NH-, insbesondere -NH-. Bei der Oxidation der Metallchelatkomplexe (Ia) mit den organischen Elektronenakzeptoren (OEA) entstehen dann die erfindungsgemäßen luftstabilen, elektrisch leitfähigen Systeme mit Grundstrukturen der allgemeinen Formel (Ib)

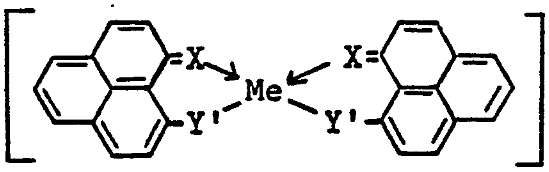 . $OEA_m$ (Ib),

worin X, Y' und Me die oben angegebene Bedeutung haben und m eine ganze Zahl zwischen 1 und 5 ist. Bevorzugte Verbindungen (Ib) sind das Bis(9-amino-1-phenalenonato)-Ni . $OEA_{1-5}$ sowie das Bis(9-amino-1-phenalenonato)-Pd . $OEA_{1-5}$.

Durch die genannten Arbeitsoperationen können elektrische Leitfähigkeitsanstiege von einigen Größenordnungen erreicht werden. Die Ausgangsleitfähigkeit der Metallchelatkomplexe (Ia) beträgt $10^{-12}\Omega^{-1}cm^{-1}$. Die erfindungsgemäßen Systeme mit Grundstrukturen der allgemeinen Formel (Ib) haben elektrische Leitfähigkeiten größer als $10^{-3}\Omega^{-1}cm^{-1}$ und sind an der Luft stabil. Bei den erfindungsgemäß hergestellten elektrisch leitfähigen polymeren Systemen handelt es sich um sogenannte p-Leiter (vgl. "J. Chem. Education", 46 (1969), (2) Seite 82), die zur antistatischen Ausrüstung von Kunststoffen, zur Herstellung von Sonnenzellen, zur Umwandlung und Fixierung von Strahlung sowie zur Herstellung elektrischer und magnetischer Schalter und elektrochemischer Speicher geeignet sind.

Die Erfindung wird durch die nachfolgenden Beispiele näher erläutert. Die in den Beispielen genannten Teile und Prozente beziehen sich, sofern nicht anders angegeben, auf das Gewicht.

**Beispiel 1**

a. Herstellung von Bis(9-amino-1-phenalenonato)Ni (II)

0,1 mol 9-Amino-1-phenalenon wurden in 700 ml Ethanol gelöst und die Lösung zum Sieden erhitzt. In die siedende Lösung wurde eine Lösung von 0,05 mol Ni(II)acetat . 4 $H_2O$ in 100 ml Ethanol/$H_2O$ (Volumenverhältnis 1 : 1) eingetropft. Es bildete sich sofort das in Ethanol unlösliche Bis(9-amino-1-phenalenonato)Ni (II) . 2 $H_2O$. Die Reaktionsmischung wurde noch 2 Stunden bei Siedetemperatur gehalten, danach die ausgefallene Substanz isoliert und im Vakuum bei 50°C entwässert. Das entstandene Bis(9-amino-1-phenalenonato)Ni (II) wurde in 80 bis 90 %iger Ausbeute als schwarzviolette Substanz erhalten. Die Leitfähigkeit betrug 6,0 . $10^{-13}$ $\Omega^{-1}cm^{-1}$.

b. Oxidation des Bis(9-amino-1-phenalenonato)Ni (II) mit Chloranil

1 g (2,23 mmol) Bis(9-amino-1-phenalenonato)Ni (II) und 2,22 g Chloranil (= 10,0 mmol) wurden in 220 ml $CCl_4$ 20 bis 30 Stunden am Rückfluß gekocht. Nach dem Abkühlen auf Zimmertemperatur wurde das unlösliche Bis(9-amino-1-phenalenonato)Ni . $Chloranil_m$ (m = 1-2) abgetrennt, mit $CCl_4$ gewaschen und bei 50°C im Hochvakuum getrocknet. Ausbeute: 100 %, Leitfähigkeit: 1,3 . $10^{-1}$ $\Omega^{-1}cm^{-1}$.

**Beispiel 2**

Es wurde analog wie in Beispiel 1 gearbeitet, jedoch wurde diesmal bei der Herstellung des Metallchelatkomplexes anstelle des Ni(II)acetat . 4 $H_2O$ eine entsprechende Menge von $PdCl_2$.2 Acetonitril eingesetzt und der entsprechende Pd(II)-Komplex (Leitfähigkeit: 5 . $10^{-12}$ $\Omega^{-1}cm^{-1}$) erhalten. Die Oxidation dieses Komplexes mit Chloranil analog Beispiel 1b führte zu einem luftstabilen Produkt mit einer elektrischen Leitfähigkeit von 1,8.$10^{+1}$ $\Omega^{-1}cm^{-1}$.

**Beispiel 3**

Es wurde wie in Beispiel 2 gearbeitet, jedoch für die Oxidation des Pd(II)-Chelatkomplexes anstelle des Chloranils Tetramethyldiphenochinon verwendet. Das erhaltene Produkt war lagerstabil und hatte eine elektrische Leitfähigkeit von 2,9.$10^{+1}$ $\Omega^{-1}cm^{-1}$.

Wird wie in Beispiel 3 gearbeitet, jedoch anstelle des Tetramethyldiphenochinons 1,4-Naphthachinon bzw. die Verbindungen der oben angegebenen allgemeinen Formeln (IX), (XI), (XII), (XXIII) mit $R^1$-$R^4$=H, (XXIII) mit $R^1$-$R^4$=CN oder (XX) eingesetzt, so werden luftstabile polymere Systeme erhalten, deren elektrische Leitfähigkeiten zwischen 0,5 . $10^{-1}$ und 3,5 . $10^{+1}$ $\Omega^{-1}cm^{-1}$ liegen.

**Patentansprüche**

1. Verfahren zur Herstellung von luftstabilen, elektrisch leitfähigen Systemen mit elektrischen Leitfähigkeitswerten größer $10^{-3}\,\Omega^{-1}cm^{-1}$ durch Umsetzen eines Metallkations der Elemente der VII., VIII. oder I. Nebengruppe des Periodischen Systems der Elemente mit einem 1,9-substituierten Phenalen der allgemeinen Formel (I)

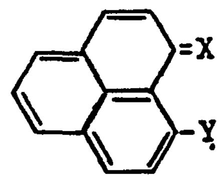

(I)

worin X = O, NH, S, Se oder Te und Y = -OH, -SH oder $-NH_2$ bedeuten, zu einem Metallchelatkomplex und Oxidation dieses Metallchelatkomplexes zu dem elektrisch leitfähigen System, dadurch gekennzeichnet, daß man als Oxidationsmittel organische Elektronenakzeptoren einsetzt.

2. Verfahren nach Anspruch 1, dadurch gekennzeichnet, daß man als Oxidationsmittel Chinone einsetzt.

3. Verfahren nach Anspruch 1, dadurch gekennzeichnet, daß man als Oxidationsmittel Chinonmethide einsetzt.

4. Verfahren nach Anspruch 1, dadurch gekennzeichnet, daß man als Oxidationsmittel Nitroaromaten einsetzt.

5. Verfahren nach Ansprüchen 1 bis 4, dadurch gekennzeichnet, daß die Metallchelatkomplexe mit einem 1,5- bis 10-fachen molaren Überschuß an organischen Elektronenakzeptoren umgesetzt werden.

6. Verfahren nach Ansprüchen 1 bis 5, dadurch gekennzeichnet, daß die Oxidation in chlorierten oder chlorfluorierten inerten Kohlenwasserstoffen als Lösungsmittel bei Temperaturen um +40 bis +100°C durchgeführt wird.

7. Verfahren nach Ansprüchen 1 bis 6, dadurch gekennzeichnet, daß als Metallkationen Fe-, Ni-, Pd-, Pt- oder Cu-Kationen eingesetzt werden.

8. Verfahren nach Ansprüchen 1 bis 7, dadurch gekennzeichnet, daß als 1,9-substituiertes Phenalen das 9-Amino-1-phenalenon eingesetzt wird.

9. Luftstabile, elektrisch leitfähige Systeme mit Grundstrukturen der allgemeinen Formel (Ib)

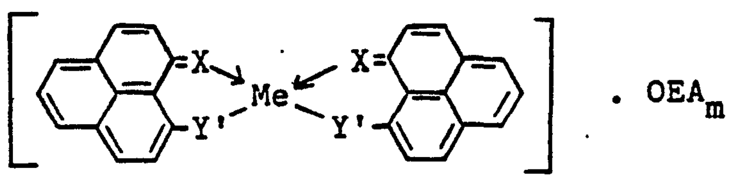

(Ib),

worin X = O, NH, S, Se oder Te; Y' = -O-, -S- oder -NH-; Me = ein Metall der VII., VIII. oder I. Nebengruppe des Periodischen Systems der Elemente; OEA = einen organischen Elektronenakzeptor und m = eine Zahl von 1 bis 5 darstellen.

10. Luftstabile, elektrisch leitfähige Systeme gemäß Anspruch 9, dadurch gekennzeichnet, daß X = O, NH oder S, insbesondere aber O ist.

11. Luftstabile, elektrisch leitfähige Systeme gemäß Ansprüchen 9 oder 10, dadurch gekennzeichnet, daß Y' = -NH- ist.

12. Luftstabile, elektrisch leitfähige Systeme gemäß Ansprüchen 9 bis 11, dadurch gekennzeichnet, daß Me = Fe, Ni, Pd, Pt oder Cu, insbesondere aber Ni, ist.

13. Luftstabile, elektrisch leitfähige Systeme gemäß Ansprüchen 9 bis 12, dadurch gekennzeichnet, daß OEA = ein Chinon, Chinonmethid oder Nitroaromat ist.

14. Verwendung der luftstabilen, elektrisch leitfähigen Systeme gemäß Ansprüchen 9 bis 13 in der Elektrotechnik zur Herstellung von Sonnenzellen, zur Umwandlung und Fixierung von Strahlung, zur Herstellung elektrischer und magnetischer Schalter sowie zur Herstellung von elektrochemischen Speichern.

15. Verwendung der luftstabilen, elektrisch leitfähigen Systeme gemäß Ansprüchen 9 bis 13 zur antistatischen Ausrüstung von Kunststoffen.

**Claims**

1. A process for the preparation of an air-stable, electrically conductive system having a conductivity greater than $10^{-3}\,\Omega^{-1}cm^{-1}$, by reacting a metal cation of an element of sub-group VII, VIII or I of the periodic table of elements with a 1,9-substituted phenalene of the general formula (I)

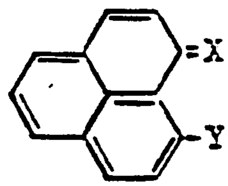

(I),

where X is O, NH, S, Se or Te and Y is -OH, -SH or $-NH_2$, to give a metal chelate, and oxidizing this metal chelate to the electrically conductive system, wherein an organic electron acceptor is employed as the oxidizing agent.

2. A process as claimed in claim 1, wherein a quinone is employed as the oxidizing agent.

3. A process as claimed in claim 1, wherein a quinone methide is employed as the oxidizing agent.

4. A process as claimed in claim 1, wherein a nitroaromatic is employed as the oxidizing agent.

5. A process as claimed in claims 1 to 4, wherein the metal chelate is reacted with a 1.5-fold to 10-fold molar excess of an organic electron acceptor.

6. A process as claimed in claims 1 to 5, wherein the oxidation is carried out in an inert chlorohydrocarbon or chlorofluorohydrocarbon as the solvent, at about +40 to +100°C.

7. A process as claimed in claims 1 to 6, wherein an Fe, Ni, Pd, Pt or Cu cation is employed as the metal cation.

8. A process as claimed in claims 1 to 7, wherein 9-amino-phenalen-1-one is employed as the 1,9-substituted phenalene.

9. An air-stable, electrically conductive system of the general formula (Ib)

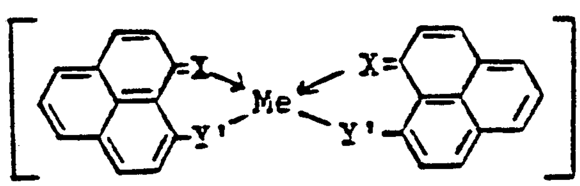

$\cdot\ OEA_m$ (Ib),

where X is O, NH, S, Se or Te, Y' is -O-, -S- or -NH-, Me is a metal of sub-group VII, VIII or I of the periodic table of elements, OEA is an organic electron acceptor, and m is a number from 1 to 5.

10. An air-stable, electrically conductive system as claimed in claim 9, wherein X is O, NH or S, especially O.

11. An air-stable, electrically conductive system as claimed in claim 9 or 10, wherein Y' is -NH-.

12. An air-stable, electrically conductive system as claimed in claims 9 to 11, wherein Me is Fe, Ni, Pd, Pt or Cu, especially Ni.

13. An air-stable, electrically conductive system as claimed in claims 9 to 12, wherein OEA is a quinone, a quinone methide or a nitroaromatic.

14. The use of an air-stable, electrically conductive system as claimed in claims 9 to 13 in electrical engineering for producing solar cells, for converting and fixing radiation, for producing electric and magnetic switches, and for producing electrochemical storage devices.

15. The use of an air-stable, electrically conductive system as claimed in claims 9 to 13 for the antistatic treatment of plastics.

**Revendications**

1. Procédé de préparation de systèmes conducteurs électriques, stables en présence d'air, avec une conductivité électrique supérieure à $10^{-3}\,\Omega^{-1}cm^{-1}$, par réaction d'un cation métallique d'un élément des groupes VIIB, VIII ou IB de la classification périodique des éléments, avec un phénalène substitué en 1 et en 9 répondant à la formule (I) générale suivante:

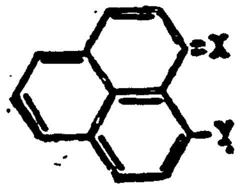

(I)

dans laquelle X = O, NH, S, Se ou Te et Y = -OH, -SH ou -$NH_2$, avec obtention d'un complexe métallique chélaté, et oxydation de ce complexe métallique chélaté en un système conducteur électrique, caractérisé en ce que, comme agent oxydant, on utilise des accepteurs d'électrons organiques.

2. Procédé selon la revendication 1, caractérisé en ce que, comme agent oxydant, on utilise une quinone.

3. Procédé selon la revendication 1, caractérisé en ce que, comme agent oxydant, on utilise um méthide de quinone.

4. Procédé selon la revendication 1, caractérisé en ce que, comme agent oxydant, on utilise un composé nitro-aromatique.

5. Procédé selon les revendications 1 à 4,caractérisé en ce que l'on fait réagir le complexe métallique chélaté avec un excès de 1,5 à 10 fois molaires d'accepteurs d'électron organiques.

6. Procédé selon les revendications 1 à 5, caractérisé en ce que l'oxydation s'effectue dans un hydrocarbure inerte chloré ou chlorofluoré, servant de solvant, à une température de +40 à +100°C.

7. Procédé selon les revendications 1 à 6, caractérisé en ce que, comme cation métallique, on utilise les cations de Fe, Ni, Pd, Pt ou Cu.

8. Procédé selon les revendications 1 à 7, caractérisé en ce que comme phénalène substitué en 1 et 9, on utilise la 9-amino-1-phénalènone.

9. Système conducteur de l'électricité stable en présence d'air, avec une structure de base répondant à la formule générale (Ib)

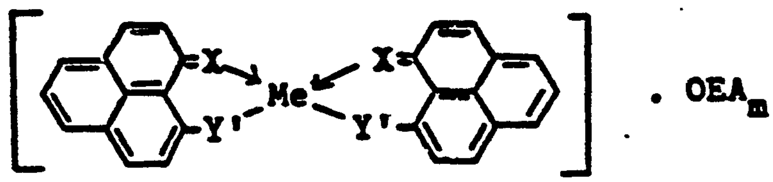

(Ib),

dans laquelle X = O, NH, S, Se ou Te; Y' = -O-, -S- ou -NH-; Me = un métal des groupes VIIB, VIII ou IB de la classification périodique des éléments; OEA = un accepteur d'électron organique et m = un nombre de 1 à 5.

10. Système conducteur électrique stable en présence d'air, selon la revendication 9, caractérisé en ce que X représente O, NH ou S, mais de préférence O.

11. Système conducteur électrique stable en présence d'air selon les revendications 9 et 10, caractérisé en ce que Y' représente NH.

12. Système conducteur électrique stable en présence d'air, selon les revendications 9 à 11, caractérisé en ce que Me représente Fe, Ni, Pd, Pt ou Cu, de préférence cependant Ni.

13. Système conducteur électrique stable en présence d'air, selon les revendications 9 à 12, caractérisé en ce que OEA représente un composé quinone, méthide de quinone ou nitroaromatique.

14. Utilisation d'un système conducteur électrique stable en présence d'air selon les revendications 9 à 13 dans le domaine de l'électrotechnique pour la préparation de cellules solaires, pour la transformation et la fixation de faisceaux, pour la préparation de commutateurs électriques et magnétiques ainsi que pour la préparation d'accumulateurs électro-chimiques.

15. Utilisation d'un système conducteur électrique stable en présence d'air, selon les revendications 9 à 13, pour le traitement anti-statique de matières plastiques.